# EUROPÄISCHE PATENTSCHRIFT

(11) **EP 3 972 449 B1**
(45) Veröffentlichungstag und Bekanntmachung des Hinweises auf die Patenterteilung: **26.04.2023**
(21) Anmeldenummer: 20727278.2
(22) Anmeldetag: 20.05.2020
(51) Int. Cl.: A47B 9/00

(54) **ELEKTROMOTORISCHE VERSTELLEINRICHTUNG FÜR EIN MÖBEL, INSBESONDERE EIN TISCHMÖBEL**
ELECTRIC-MOTOR ADJUSTMENT DEVICE FOR A PIECE OF FURNITURE, IN PARTICULAR A PIECE OF TABLE FURNITURE
DISPOSITIF DE RÉGLAGE À MOTEUR ÉLECTRIQUE POUR UN MEUBLE, EN PARTICULIER UNE TABLE

(30) Priorität: 20.05.2019 DE 202019102842 U
(43) Veröffentlichungstag der Anmeldung: 30.03.2022
(73) Patentinhaber: DewertOkin Technology Group Co., Ltd., Jiaxing City, Zhejiang Province (CN)
(72) Erfinder: HILLE, Armin, 33659 Bielefeld (DE)
(74) Vertreter: Kleine, Hubertus
(86) Internationale Anmeldenummer: PCT/EP2020/064054
(87) Internationale Veröffentlichungsnummer: WO 2020/234343

(56) Entgegenhaltungen:
- DE-U1-202010 005 411

## Beschreibung

Die Erfindung betrifft eine elektromotorische Verstelleinrichtung für ein Möbel, insbesondere ein Tischmöbel, mit mindestens einer Antriebseinheit zur Verstellung eines bewegbaren Möbelteils. Die Verstelleinrichtung weist eine Steuereinrichtung zum Ansteuern der mindestens einen Antriebseinheit auf, wobei die Steuereinrichtung zur Befestigung an dem bewegbaren Möbelteil eingerichtet ist und wobei innerhalb eines Gehäuses der Steuereinrichtung ein Sensor angeordnet ist, um Verformung des Möbelteils zu detektieren und die Antriebseinheit bei detektierter Verformung abzuschalten.

Elektromotorische Verstelleinrichtungen werden in verschiedensten Ausführungen zur Bewegung von bewegbar an einem Möbel angelenkten Möbelteilen eingesetzt. Beispiele sind eine Neigungs- oder Höhenverstellung von Abschnitten eines Bettes oder eines sonstigen Sitz- oder Liegemöbels oder eine Höhenverstellung einer Tischplatte.

Da die Antriebseinheiten der Verstelleinrichtungen dazu ausgelegt sind, das Möbelteil auch unter Belastung zu verstellen, wirken Kräfte, die im Fall eines Einklemmens eines Körperteils oder eines sonstigen Gegenstands zu Verletzung oder zur Zerstörung der Gegenstände oder des Möbels führen könnten. Um dieses zu verhindern, ist häufig ein Einklemmschutz vorgesehen, der beim Detektieren eines Einklemmfalls die Antriebseinheit abschaltet oder zunächst kurz in eine entgegengesetzte Richtung laufen lässt und dann abschaltet. Ein bekannter Einklemmschutz ist beispielsweise über Kontaktschalter oder Schalterleisten realisiert, die an Abschnitten des Möbelteils angeordnet sind, bei denen potentiell ein Einklemmen auftreten kann und die durch Körperteile oder Gegenstände ausgelöst werden. Insbesondere bei höhenverstellbaren Tischen, bei denen die Tischplatte das bewegbare Möbelteil darstellt, ist es aufwendig, die gesamte Tischplatte, beispielsweise entlang ihres Umfangs, mit Schaltleisten zu versehen. Zudem stören die Schaltleisten oder können die Schaltleisten das Design des Tischmöbels stören.

Aus der Druckschrift DE 10 2011 050 159 A1 ist ein alternativer Einklemmschutz beschrieben, bei dem eine Verformung des Möbelteils, also beispielsweise der Tischplatte, selbst detektiert wird, um einen Einklemmfall zu erkennen. Zu diesem Zweck ist in einer bevorzugten Ausgestaltung ein flächiger piezo-elektrischer Sensor auf die Fläche des Möbelteils aufgebracht. Eine Verformung des Möbelteils kann von dem Sensor detektiert werden und als Einklemmfall interpretiert werden. Der Sensor ist dabei von einem Gehäuse umgeben, das an der Position des Sensors eine Aussparung aufweist, sodass der Sensor unmittelbar das Möbelteil kontaktiert. Als eine Alternative ist in der genannten Druckschrift beschrieben, den Piezo-Sensor unmittelbar von innen im Gehäuse an einen Gehäuseboden aufzubringen, wobei der Gehäuseboden flächig auf dem Möbelteil aufliegt. Diese Ausgestaltung vereinfacht die Montage der Sensoreinheit, die Empfindlichkeit des Sensors sinkt jedoch, wodurch ein Einklemmfall unter Umständen nicht mehr mit der geforderten Sicherheit detektiert werden kann. Eine weitere gattungsgemäße, elektromotorische Verstelleinrichtung ist bereits aus der DE 20 2010 005411 U1 bekannt.

Es ist daher eine Aufgabe der vorliegenden Erfindung, eine elektromotorische Verstelleinheit der eingangs genannten Art zu beschreiben, die einschließlich des Einklemmschutzes über den Sensor einfach zu montieren ist und die dennoch einen Einklemmfall mit einer hohen Sicherheit detektieren kann.

Diese Aufgabe wird durch eine elektromotorische Verstelleinrichtung mit den Merkmalen des unabhängigen Anspruchs gelöst. Vorteilhafte Ausgestaltungen und Weiterbildungen sind Gegenstand der abhängigen Ansprüche.

Eine erfindungsgemäße Verstelleinrichtung zeichnet sich dadurch aus, dass ein Übertragungselement vorhanden ist, das mit dem Möbelteil in Kontakt steht und eine Verformung des Möbelteils auf den Sensor überträgt.

Durch das Übertragungselement kann eine Verformung des Möbelteils auf den Sensor übertragen werden, ohne dass der Sensor so im oder am Gehäuse positioniert werden muss, dass der Sensor selbst die Verformung des Möbelteils unmittelbar erfassen kann. Das vereinfacht den Aufbau der Verstelleinrichtung und insbesondere die Anordnung des Sensors innerhalb des Gehäuses der Verstelleinrichtung.

Erfindungsgemäß ist ein Abschnitt des Gehäuses als Übertragungsabschnitt ausgebildet. Die Ausgestaltung eines Abschnitts des Gehäuses als Übertragungsabschnitt, der das Möbelteil kontaktiert und Verformungen auf den Sensor überträgt, stellt sicher, dass auch ein innerhalb des Gehäuses angeordneter Sensor Verformungen des Möbelteils mit der geforderten Empfindlichkeit detektieren kann. Der Übertragungsabschnitt weist erfindungsgemäß ein Tastelement auf, das das Möbelteil kontaktiert.

In einer weiteren vorteilhaften Ausgestaltung der Verstelleinrichtung kann der Übertragungsabschnitt dabei ein Abschnitt des Gehäuses sein, der als Federzunge ausgebildet ist und nur in einem Teil seines Umfangs mit benachbarten Bereichen des Gehäuses verbunden ist. Bevorzugt kann der Übertragungsabschnitt dabei einstückig, z.B. aus einem Guss, mit dem Gehäuseteil ausgebildet sein. Die einstückige, integrale Ausgestaltung ermöglicht eine kostengünstige Herstellung und einfache Montage.

In einem nicht erfindungsgemäßen Beispiel ist das Übertragungselement als separates Bauelement ausgebildet und dem Gehäuse zugeordnet.

In diesem Beispiel kann das Übertragungselement an dem Gehäuse befestigt sein. Es kann jedoch in diesem nicht erfindungsgemäßen Beispiel auch vorgesehen sein, dass das Übertragungselement durch eine Öffnung des Gehäuses zumindest abschnittsweise hindurch geführt ist und mit einem ersten Bereich das Möbelteil kontaktiert. Ein zweiter Bereich eines solchen Übertragungselements ist zur Übertragung einer Verformung des Möbelteils auf den Sensor ausgebildet.

Erfindungsgemäß ist der Sensor unmittelbar auf einer Leiterplatte im Gehäuse der Steuereinrichtung angeordnet. Dadurch vereinfacht sich der Aufbau der Steuereinrichtung, die entsprechend kostengünstiger produziert werden kann. Erfindungsgemäß weist die Leiterplatte, auf der der Sensor angeordnet ist, auch Steuerelemente zum Ansteuern der mindestens einen Antriebseinheit auf, ist also die oder einer der Hauptleiterplatten der Steuereinrichtung, die in jedem Fall vorhanden ist. Es braucht so keine zusätzliche Leiterplatte oder sonstige Befestigungsmöglichkeit für den Sensor vorhanden sein. Als Steuerelemente kommen Relaisschalter, Halbleiterschalter sowie dessen Ansteuerungen wie Prozessoren oder Controller in Betracht.

In einer weiteren vorteilhaften Ausgestaltung der elektromotorischen Verstelleinrichtung arbeitet der Sensor kapazitiv und wirkt berührungslos mit dem Übertragungsabschnitt zusammen. Alternativ kann der Sensor induktiv arbeiten und berührungslos mit dem Übertragungselement, z.B. dem Übertragungsabschnitt, oder einem an dem Übertragungselement bzw. -abschnitt angeordneten ferro-, para- oder diamagnetischem Element zusammenwirken. Als eine weitere Alternative kann der Sensor piezoelektrisch arbeiten und/oder Dehnungsmesselemente aufweisen, wobei er in dem Fall direkt oder indirekt mechanisch mit dem Übertragungselement gekoppelt wird.

Weiter kann der Sensor eine Ringspule sein, die auf der Leiterplatte angeordnet ist und durch deren Öffnung ein Befestigungselement, z.B. eine Befestigungsschraube, führt, mit dem die Steuereinrichtung auf dem bewegbaren Möbelteil befestigt wird. Die Leiterplatte wird dabei innerhalb des Gehäuses in einem Bereich gehalten, der benachbart zu dem Übertragungselement liegt. Auf diese Weise überträgt sich eine Verformung des Möbelteils in eine Relativbewegung zwischen der Ringspule und dem Befestigungselement, wodurch sich eine Induktivität der Ringspule ändert, was wiederum erfasst werden kann.

In einer weiteren vorteilhaften Ausgestaltung der elektromotorischen Verstelleinrichtung ist vorgesehen, dass im nicht montierten Zustand der Verstelleinrichtung im Möbel das Übertragungselement über äußere Grenzen des Gehäuses hervorragt. Damit ist sichergestellt, dass nach der Montage der Steuereinrichtung am Möbelteil bzw. im Möbel der Übertragungsabschnitt bzw. das Übertragungselement stets etwas vorgespannt ist und diese Vorspannung im geringen Maße auf den Sensor überträgt. Insbesondere wird damit eine spielfreie Kopplung und Bewegungsübertragung vom Möbelteil auf den Sensor gewährleistet. Das Maß an Überstand bzw. das geometrische Maß an Vorspannung kann zwischen etwa 0,5 Millimetern (mm) und etwa 3 mm betragen.

Der Funktions- und Verfahrensablauf der Anordnung, insbesondere eine als elektromotorisches Möbel ausgebildeter höhenverstellbarer Tisch, ist nun wie folgt: Während des vertikalen Verstellvorganges kann eine unerwünschte Betriebssituation auftreten. Verfährt die Tischplatte gegen einen ortsfesten Gegenstand oder gegen ein Körperteil, so verformt sich die Tischplatte um ein gewisses Maß. Da die Befestigungen des Steuergehäuses an dem Möbelteil bzw. an der Tischplatte relativ weit voneinander beabstandet sind, und der Übertragungsabschnitt bzw. das Übertragungselement im Abstand zu den Befestigungspunkten angeordnet ist, erfolgt schon bei bereits kleinen Verformungen der Tischplatte eine relativ große Bewegung des Übertragungsabschnitts bzw. des Übertragungselements, was wiederrum zu einer guten Detektionsfähigkeit des Sensors führt. Der Sensor ist mit einer Auswerteinrichtung elektrisch gekoppelt, welche über einen Controller mit einem darauf lauffähigen Programm verfügt. Das Programm weist dabei einen Verfahrensschritt auf, welcher ausschließlich sich rasch verändernde Signale am Sensorausgang als eine eingangs genannte unerwünschte Betriebssituation klassifiziert, und sodann alle Motore unverzüglich abschaltet. Nach dem Abschaltvorgang aller Motore kann in einem weiteren Verfahrensschritt der selbsttätige Betrieb des wenigstens einen Elektromotors in die umgekehrte Drehrichtung erfolgen. Die Dauer dieses Betriebs kann zeitlich begrenzt sein und kann z.B. 0,5 bis 1 Sekunde betragen.

Die Erfindung wird nachfolgend anhand von Ausführungsbeispielen mit Hilfe von Figuren näher erläutert. Die Figuren zeigen:
- Figur 1: eine schematische Darstellung einer Steuereinrichtung montiert auf einem Möbelteil in einer ersten Ausführungsform;
- Figur 2: eine schematische Darstellung einer Steuereinrichtung montiert auf einem Möbelteil eines nicht erfindungsgemäßen Beispiels einer elektromotorischen Verstelleinrichtung;
- Figur 3: eine schematische Darstellung einer Steuereinrichtung montiert auf einem Möbelteil in einer zweiten Ausführungsform;
- Figur 4: eine schematische Darstellung einer Steuereinrichtung montiert auf einem Möbelteil in einer dritten Ausführungsform.

In den nachfolgend beschriebenen Figuren ist jeweils ein Ausführungsbeispiel einer Steuereinrichtung einer elektromotorischen Verstelleinrichtung in einer schematischen Schnittzeichnung wiedergegeben. In allen Ausführungsbeispielen kennzeichnen gleiche Bezugszeichen gleiche oder gleichwirkende Elemente.

In allen Ausführungsbeispielen ist eine Steuereinrichtung 10 gezeigt, die auf einem Möbelteil 1 montiert ist. Das Möbelteil ist beispielsweise eine Tischplatte, die mittels der elektromotorischen Verstelleinrichtung höhenverstellbar ist. Zur elektromotorischen Verstelleinrichtung gehört dann mindestens ein, im Fall von höhenverstellbaren Tischen in der Regel zwei Antriebseinheiten, die beispielsweise als Hubsäulen ausgebildet sein können, auf denen die Tischplatte als Möbelteil 1 montiert ist. Die hier nicht dargestellten Antriebseinheiten sind ebenso wie ein Stromversorgungskabel mit der Steuereinrichtung 10 verbunden. Üblicherweise ist auch eine Bedieneinheit vorhanden, die über ein Kabel oder drahtlos mit der Steuereinrichtung 10 gekoppelt ist und über die die Steuereinrichtung 10 zur Aktivierung der Antriebseinheiten angewiesen werden kann.

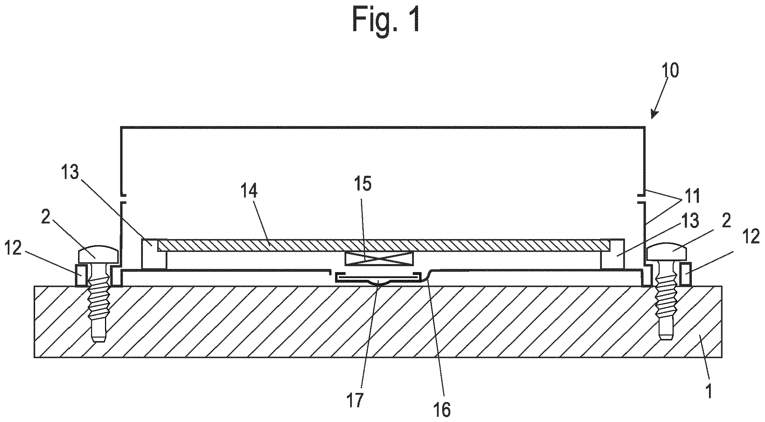

In allen gezeigten Ausführungsbeispielen weist die Steuereinrichtung 10 ein Gehäuse 11 auf, das in den gezeigten Beispielen jeweils zweiteilig ausgebildet ist und ein Gehäuseunterteil sowie ein Gehäuseoberteil umfasst. In allen Fällen könnte auch ein einteiliges Gehäuse oder auch ein mehrteiliges Gehäuse eingesetzt sein. Das Gehäuse 11 weist mindestens einen Gehäusefuß 12 auf, durch den jeweils eine Befestigungsschraube 2 führt, mit der oder mit denen die Steuereinrichtung 10 am Möbelteil 1 befestigt ist. Bei den Ausführungsbeispielen der Figuren 1 bis 3 sind jeweils mindestens zwei Gehäusefüße 12 und Befestigungsschrauben 2 vorgesehen, die an gegenüberliegenden Seiten des Gehäuses 11 der Steuereinrichtung 10 angeordnet sind. Durch diese Art der Befestigung liegt das Gehäuse 11 mit den Gehäusefüßen 12 fest auf dem Möbelteil 1, also beispielsweise der Tischplatte auf.

Im Inneren des Gehäuses 11 ist eine Leiterplatte 14 angeordnet, die in bekannter Weise auf Leiterlattenaufnahmen 13 aufliegt. Solche Leiterplattenaufnahmen 13 unterstützen die Leiterplatte 14 an mehreren, mindestens drei und in der Regel vier oder mehr Auflagepunkten. Die Leiterplattenaufnahmen 13 können bevorzugt integral in einem Spritzgussverfahren mit dem Gehäuse 11 ausgebildet sein. Im Bereich der Leiterplattenaufnahmen 13 oder separat davon können Laschen mit Rastnasen vorgesehen sein, die die Leiterplatte 14 übergreifen und somit eine schnelle und unkomplizierte Montage der Leiterplatten 14 im Gehäuse 11 ermöglichen.

Beim Ausführungsbeispiel der Figur 1 ist an einer Unterseite der Leiterplatte 14, d.h. an einer zum Möbelteil 1 weisenden Seite ein Sensor 15 angeordnet, der beim Ausführungsbeispiel der Figur 1 ein induktiv oder kapazitiv arbeitender Sensor ist. Als induktiv arbeitender Sensor kann eine Spule oder auch ein Hall-Sensor eingesetzt werden.

Der Sensor 15 ist bevorzugt als Bauteil auf der Leiterplatte 14 angeordnet. Eine darüber hinaus gehende Befestigung des Sensors 15 ist vorteilhaft nicht vorhanden, sodass der Sensor 15 in dem üblichen Bestückungsprozess, den die Leiterplatte 14 durchläuft, auf dieser angeordnet werden kann. Bei Verwendung einer Spule kann diese ein separates Bauelement sein, das auf der Leiterplatte positioniert ist. Die Spule kann aber auch als Planarspule durch Leiterbahnen der Leiterplatte 14 gebildet sein. In einer Ausgestaltung als kapazitiv arbeitender Sensor 15 können Leiterbahnen der Leiterplatte 14 selbst den Sensor 15 bilden. Im Fall eines kapazitiv arbeitenden Annäherungssensors können beispielsweise nebeneinander angeordnete, gegebenenfalls kammartig ineinander verschränkte Leiterbahnen als Elektroden des Sensors 15 eingesetzt werden.

Unmittelbar im Bereich des Sensors 15 ist ein Abschnitt 16 des Gehäuses 11 dazu eingerichtet, eine Verformung des Möbelteils 1 aufzunehmen und auf den Sensor 15 zu übertragen. Dieser Abschnitt 16 wird im Folgenden auch Übertragungsabschnitt 16 genannt und stellt ein Übertragungselement dar. Er weist ein Tastelement 17 auf, das bis auf das Möbelteil 1 hinab ragt. Im Ausführungsbeispiel der Figur 1 ist der Übertragungsabschnitt 16 als eine Federzunge ausgebildet, die entlang eines Großteils ihres Umfangs durch einen Spalt von dem umgebenden Bereich des Gehäuses 11 getrennt ist und nur in einem Verbindungsabschnitt, der beispielsweise durch ein oder mehrere Stege gebildet sein kann, mit dem übrigen Teil des Gehäuses 11 verbunden ist. Der Verbindungsabschnitt kann gekröpft ausgebildet sein, um den Übertragungsabschnitt 16 in Richtung des Möbelteils 1 hervorstehen zu lassen. Es kann alternativ auch ein größerer Bereich des Bodens des Gehäuses 11 ausgestellt sein, um den Übertragungsabschnitt 16 näher am Möbelteil 1 zu positionieren. Alternativ kann der Übertragungsabschnitt 16 auch in der gleichen Ebene wie der umgebende Bereich des Gehäuses 11 angeordnet sein, wobei dann ein entsprechend langes Tastelement 17 eingesetzt wird.

Bei Verwendung eines induktiven Sensors 15 kann auf einer Oberseite des Übertragungsabschnitts 16, die in Richtung der Leiterplatte 14 weist, z.B. ein ferro- oder paramagnetisches, ggf. auch oder permanentmagnetisches Element angeordnet sein.

Beim Betrieb der Steuereinrichtung 10 führt ein Einklemmfall, also in einer unerwünschten Betriebssituation, zu einer Verformung, beispielsweise Verbiegung oder Verwindung des Möbelteils 1. Dadurch ändert sich die relative Position der Oberfläche des Möbelteils 1 im Bereich des Sensors 15 gegenüber ihrer Position im Bereich der Gehäusefüße 12. Diese Änderung wird vom Tastelement 17 auf den Übertragungsabschnitt 16 übertragen. Der Sensor 15 detektiert eine Positionsänderung des Übertragungsabschnitts 16 auf kapazitive oder induktive Art durch Veränderung der die elektrischen (im kapazitiven Fall) oder der para- oder diamagnetischen (im induktiven Fall) Umgebung des Sensors 15. Hierbei sind insbesondere Änderungen relevant, die zum Einen besser detektiert werden können als absolute Werte und die zum Anderen eine je nach Montagesituation und Oberflächenbeschaffenheit des Möbelteils 1 unterschiedliche Ausgangspositionen des Tastelements 17 ausblenden.

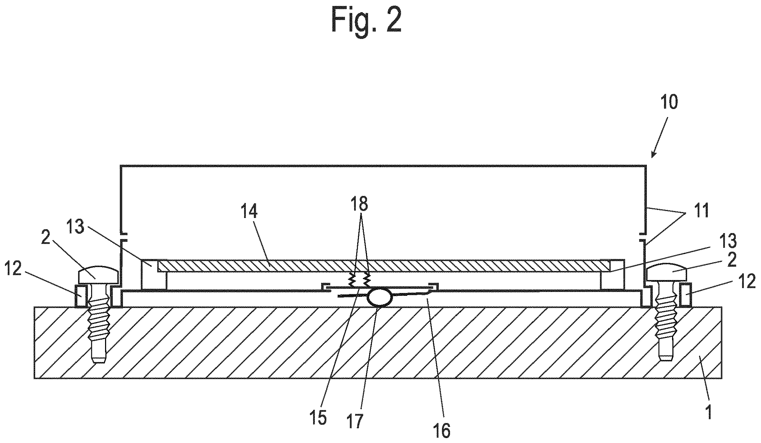

Figur 2 zeigt ein nicht erfindungsgemäßes Beispiel einer Steuereinrichtung 10. Bezüglich des Aufbaus des Gehäuses 11 und der Anordnung der Leiterplatte 14 entspricht das zweite Ausführungsbeispiel dem Ersten, auf dessen Beschreibung hiermit explizit verwiesen wird.

Im Unterschied zum ersten Ausführungsbeispiel ist beim Beispiel der Figur 2 ein piezo-elektrischer Sensor 15 verwendet. Ein weiterer Unterschied ist, dass der Sensor 15 nicht unmittelbar auf der Leiterplatte 14 angeordnet ist, sondern in eine Aufnahme des Gehäuses 11 eingesetzt, die im Bereich des Übertragungsabschnitts 16 liegt. Um auch in diesem Fall eine möglichst einfache Montage der Steuereinrichtung 10 zu erreichen, erfolgt eine Kontaktierung des Sensors 15 über Kontaktfedern 18, die entweder am Sensor 15 befestigt sein können oder an der Leiterplatte 14. Beim Zusammensetzen der Steuereinrichtung 10 wird der Sensor 15 somit ohne die Notwendigkeit Kabelverbindungen zu erstellen von der Leiterplatte 14 kontaktiert. Das Tastelement 17 ist so ausgelegt, dass er einerseits das Möbelteil 1 und andererseits eine Oberfläche des Sensors 15 kontaktiert. Um im Hinblick auf die Grundposition des Tastelements 17 noch variabler zu sein, kann in einer alternativen Ausgestaltung vorgesehen sein, dass das Tastelement 17 bis auf das Möbelteil 1 ragt und vom Übertragungsabschnitt 16 ein davon separates, bevorzugt federndes Element auf den Sensor 15 drückt und eine Bewegung des Tastelements 17 über den Übertragungsabschnitt 16 und dieses separate Element erfolgt.

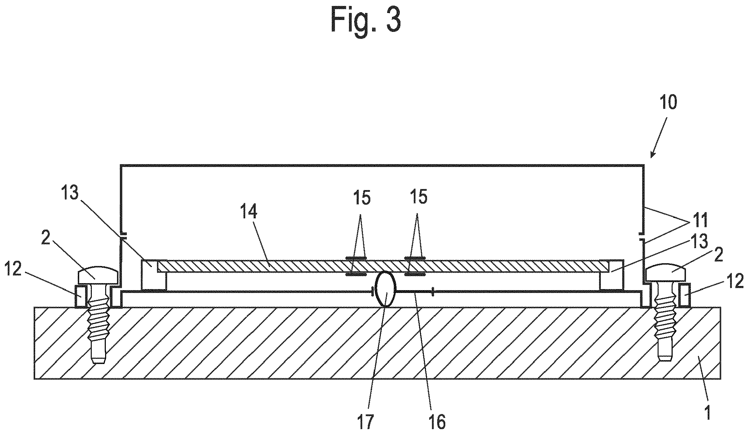

Figur 3 zeigt ein zweites Ausführungsbeispiel. Bei diesem ist ähnlich wie beim Beispiel der Figur 1 der Sensor 15 unmittelbar auf der Leiterplatte 14 angebracht. Als Sensor 15 sind im Ausführungsbeispiel der Figur 3 Dehnungsmessstreifen eingesetzt, bevorzugt werden vier Dehnungsmessstreifen eingesetzt, die in einer Brückenschaltung ausgewertet werden können. Eine Verformung des Möbelteils 1 wird über das Tastelement 17 und den Übertragungsabschnitt 16 auf die Leiterplatte 14 übertragen, die sich entsprechend ebenfalls verformt, was vom Sensor 15 erfasst wird.

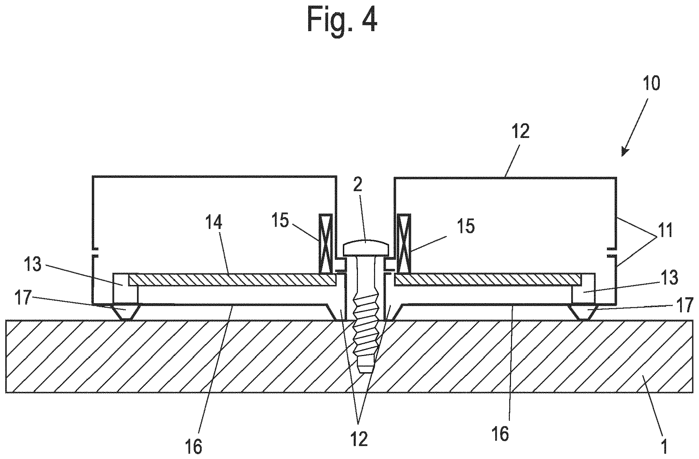

In Figur 4 ist ein weiteres Ausführungsbeispiel einer Steuereinrichtung 10 gezeigt. Bei dieser ist eine zentrale Befestigung am Möbelteil 1 mit nur einer Befestigungsschraube 2 vorgesehen, die durch einen zentralen Gehäusefuß 12 führt. In diesem Bereich durchdringt der Gehäusefuß 12 und auch die Befestigungsschraube 2 auch die Leiterplatte 14, die entsprechend ausgespart ist.

Ansonsten ist die Leiterplatte 14 wie zuvor in einem Außenbereich mit Hilfe von Leiterplattenaufnahmen 13 gehalten. Die Leiterplatte 14 ist in dem zentralen Bereich nicht am Gehäuse 11 festgelegt.

Im Außenbereich des Gehäuses 11 sind weitere Auflagepunkte des Gehäuses auf dem Möbelteil 1 vorgesehen, die im Sinne der Anmeldung Tastelemente 17 darstellen.

Als Sensor 15 ist auf der Leiterplatte 14 zentral eine Ringspule angeordnet, die den Gehäuseabschnitt, durch den die Befestigungsschraube 2 führt, umgibt.

Bei Verformung des Möbelteils 1 verändert sich die Position der Tastelemente 17 am Rand des Gehäuses 11 gegenüber dem zentral angeordneten Gehäusefuß 12. Entsprechend wird gegenüber dem Gehäusefuß 12 die Leiterplatte 14 angehoben bzw. abgesenkt. Mit der Bewegung der Leiterplatte 14 gegenüber dem Gehäusefuß 12 und der Befestigungsschraube 2 verändert sich auch die Position der Ringspule als Sensor 15 gegenüber dem Gehäusefuß 12 und insbesondere der Befestigungsschraube 2. Diese Änderung führt zu einer Änderung der Induktivität der Ringspule, die erfasst werden kann. Bevorzugt ist die Ringspule Teil eines Resonanzkreises, dessen Resonanzfrequenz erfasst wird. Eine Änderung der relativen Position der Ringspule zur Befestigungsschraube 2 führt zu einer Änderung der Resonanzfrequenz, die einen Einklemmfall anzeigt. Übersteigt beispielsweise die Frequenzänderung einen vorgegebenen Wert, kann dieses als Einklemmfall angesehen werden und die Steuereinrichtung 10 stoppt alle laufenden Antriebseinheiten oder lässt sie kurze Zeit in Gegenrichtung laufen, bevor sie sie danach stoppt.

### Bezugszeichenliste

- 1: Möbelteil
- 2: Befestigungsschraube

- 10: Steuereinrichtung
- 11: Gehäuse
- 12: Gehäusefuß
- 13: Leiterplattenaufnahme
- 14: Leiterplatte
- 15: Sensor
- 16: Übertragungsabschnitt
- 17: Tastelement
- 18: Kontaktfeder

## Patentansprüche

1. Elektromotorische Verstelleinrichtung für ein Möbel, insbesondere ein Tischmöbel, mit mindestens einer Antriebseinheit zur Verstellung eines bewegbaren Möbelteils (1), aufweisend eine Steuereinrichtung (10) zum Ansteuern der mindestens einen Antriebseinheit, wobei die Steuereinrichtung (10) zur Befestigung an dem bewegbaren Möbelteil (1) eingerichtet ist und wobei innerhalb eines Gehäuses (11) der Steuereinrichtung (10) ein Sensor (15) angeordnet ist, um Verformung des Möbelteils zu detektieren und die Antriebseinheit bei detektierter Verformung abzuschalten, wobei mindestens ein Übertragungselement vorhanden ist, das mit dem Möbelteil (1) in Kontakt steht und eine Verformung des Möbelteils (1) auf den Sensor (15) überträgt, wobei ein Abschnitt des Gehäuses (11) als Übertragungsabschnitt (16) ausgebildet ist und mit einem Tastelement (17) versehen ist, das mit dem Möbelteil (1) in Kontakt steht und **dadurch gekennzeichnet, dass** der Sensor (15) unmittelbar auf einer Leiterplatte (14) im Gehäuse (11) der Steuereinrichtung (10) angeordnet ist, wobei die Leiterplatte auch Steuerelemente zum Ansteuern der mindestens einen Antriebseinheit aufweist.

2. Elektromotorische Verstelleinrichtung nach Anspruch 1, bei der der Übertragungsabschnitt (16) als Federzunge ausgebildet ist, die nur in einem Teil ihres Umfangs mit benachbarten Bereichen des Gehäuses (11) verbunden ist.

3. Elektromotorische Verstelleinrichtung nach Anspruch 1 oder 2, bei der der Sensor (15) kapazitiv arbeitet und berührungslos mit dem Übertragungselement zusammenwirkt.

4. Elektromotorische Verstelleinrichtung nach Anspruch 1 oder 2, bei der der Sensor (15) piezoelektrisch arbeitet und/oder Dehnungsmesselemente aufweist.

5. Elektromotorische Verstelleinrichtung nach Anspruch 1 oder 2, bei der der Sensor (15) induktiv arbeitet und berührungslos mit dem Übertragungselement oder einem an dem Übertragungselement angeordneten ferro-, para- oder diamagnetischem Element zusammenwirkt.

6. Elektromotorische Verstelleinrichtung nach Anspruch 1 oder 2, bei der der Sensor (15) eine Ringspule ist, die auf der Leiterplatte (14) angeordnet ist und durch die eine Befestigungsschraube (2) führt, wobei die Leiterplatte (14) innerhalb des Gehäuses (11) in einem Bereich gehalten wird, der benachbart zu dem Übertragungselement ist.

7. Elektromotorische Verstelleinrichtung nach einem der Ansprüche 1 bis 6, bei der das Übertragungselement in einem nicht montierten Zustand der Verstelleinrichtung über äußere Grenzen des Gehäuses (11) hinausragt.

## Claims

1. Electromotive adjusting device for a piece of furniture, in particular a piece of table furniture, having at least one drive unit for adjusting a movable furniture part (1), having a control device (10) for actuating the at least one drive unit, wherein the control device (10) is set up for fastening to the movable furniture part (1), and wherein a sensor (15) is arranged inside a housing (11) of the control device (10) in order to detect deformation of the furniture part and to switch off the drive unit when deformation is detected, wherein at least one transmission element is provided which is in contact with the furniture part (1) and transmits a deformation of the furniture part (1) to the sensor (15), wherein a section of the housing (11) is formed as a transmission section (16) and is provided with a sensing element (17) which is in contact with the furniture part (1), **characterized in that** the sensor (15) is arranged directly on a printed circuit board (14) in the housing (11) of the control device (10), wherein the printed circuit board also comprises control elements for actuating the at least one drive unit.

2. Electromotive adjusting device according to claim 1, in which the transmission section (16) is formed as a spring tongue which is connected to adjacent areas of the housing (11) only in a part of its circumference.

3. Electromotive adjusting device according to claim 1 or 2, in which the sensor (15) operates capacitively and interacts with the transmission element without contact.

4. Electromotive adjusting device according to claim 1 or 2, in which the sensor (15) operates piezoelectrically and/or comprises strain measuring elements.

5. Electromotive adjusting device according to claim 1 or 2, in which the sensor (15) operates inductively and interacts without contact with the transmission element or a ferromagnetic, paramagnetic or diamagnetic element arranged on the transmission element.

6. Electromotive adjusting device according to claim 1 or 2, in which the sensor (15) is a ring coil disposed on the printed circuit board (14) and through which a fixing screw (2) passes, wherein the printed circuit board (14) is retained within the housing (11) in a region adjacent to the transmission element.

7. Electromotive adjusting device according to one of claims 1 to 6, in which the transmission element protrudes beyond outer limits of the housing (11) in a non-assembled state of the adjusting device.

## Revendications

1. Dispositif d'ajustement à moteur électrique pour un meuble, en particulier une table, avec au moins une unité d'entraînement pour l'ajustement d'une partie de meuble mobile (1), comportant un dispositif de commande (10) pour la commande de l'au moins une unité d'entraînement, le dispositif de commande (10) étant conçu pour être fixé sur la partie de meuble mobile (1) et un capteur (15) étant disposé à l'intérieur d'un boîtier (11) du dispositif de commande (10) pour détecter les déformations de la partie de meuble et arrêter l'unité d'entraînement si une déformation est détectée, dans lequel est prévu au moins un élément de transmission qui est en contact avec la partie de meuble (1) et transmet une déformation de la partie de meuble (1) au capteur (15), dans lequel une partie du boîtier (11) est conformée comme une section de transmission (16) et munie d'un élément palpeur (17) qui est en contact avec la partie de meuble (1), **caractérisé en ce que** le capteur (15) est directement disposé sur une carte de circuits (14) dans le boîtier (11) du dispositif de commande (10), laquelle carte de circuits comporte aussi des éléments de commande pour commander l'au moins une unité d'entraînement.

2. Dispositif d'ajustement à moteur électrique selon la revendication 1, dans lequel la section de transmission (16) est conformée comme une languette de ressort qui n'est reliée aux zones voisines du boîtier (11) que sur une partie de sa circonférence.

3. Dispositif d'ajustement à moteur électrique selon la revendication 1 ou 2, dans lequel le capteur (15) a un fonctionnement capacitif et coopère sans contact avec l'élément de transmission.

4. Dispositif d'ajustement à moteur électrique selon la revendication 1 ou 2, dans lequel le capteur (15) a un fonctionnement piézoélectrique et/ou comporte des éléments de mesure de l'allongement.

5. Dispositif d'ajustement à moteur électrique selon la revendication 1 ou 2, dans lequel le capteur (15) fonctionne par induction et coopère sans contact avec l'élément de transmission ou avec un élément ferromagnétique, paramagnétique ou diamagnétique disposé sur l'élément de transmission.

6. Dispositif d'ajustement à moteur électrique selon la revendication 1 ou 2, dans lequel le capteur (15) est une bobine toroïdale qui est disposée sur la carte de circuits (14) et à travers laquelle passe une vis de fixation (2), la carte de circuits (14) étant retenue à l'intérieur du boîtier (11) dans une zone voisine de l'élément de transmission.

7. Dispositif d'ajustement à moteur électrique selon l'une des revendications 1 à 6, dans lequel l'élément de transmission dépasse au-delà des limites extérieures du boîtier (11) dans un état non monté du dispositif d'ajustement.
